Europäisches Patentamt

European Patent Office

Office européen des brevets

(19)

(11) Veröffentlichungsnummer: **0 175 259**
**B1**

# EUROPÄISCHE PATENTSCHRIFT

(12)

(45) Veröffentlichungstag der Patentschrift:
**02.09.87**

(21) Anmeldenummer: **85111398.5**

(22) Anmeldetag: **10.09.85**

(51) Int. Cl.⁴: **B 32 B 27/32,** C 23 C 14/00

(54) **Transfermetallisierungsfolie.**

(30) Priorität: **19.09.84 DE 3434298**

(43) Veröffentlichungstag der Anmeldung:
**26.03.86 Patentblatt 86/13**

(45) Bekanntmachung des Hinweises auf die Patenterteilung:
**02.09.87 Patentblatt 87/36**

(84) Benannte Vertragsstaaten:
**BE DE FR GB IT NL**

(56) Entgegenhaltungen:
**EP-A-0 038 878**

(73) Patentinhaber: **HOECHST AKTIENGESELLSCHAFT,
Postfach 80 03 20, D-6230 Frankfurt am Main 80
(DE)**

(72) Erfinder: **Crass, Günther, Bachstrasse 7, D-6204
Taunusstein 4 (DE)**
Erfinder: **Paschke, Klaus, Peterstrasse 9, D-6650
Homburg- Reiskirchen (DE)**
Erfinder: **Bothe, Lothar, Dr., Am Heiligenhaus 9,
D-6500 Mainz- Gonsenheim (DE)**

## Beschreibung

Die vorliegende Erfindung bezieht sich auf eine biaxial streckorientierte Transfermetallisierungsfolie auf Basis von Polypropylen.

Für spezielle Verpackungszwecke besteht ein hoher Bedarf an Verbundmaterialien aus Papier und Metall, insbesondere Aluminiumfolie, der von Jahr zu Jahr höher steigt. Obgleich für derartige Verbundmaterialien schon extrem dünne Metallfolien eingesetzt werden und auch ausreichend sind, werden weitere Einsparungen des knappen und kostenintensiven Metalls durch den Einsatz metallisierter Papiere angestrebt. Die Metallisierung von Papier wird nach dem Stand der Technik nach zwei voneinander verschiedenen Verfahren durchgeführt. Nach dem ersten Verfahren wird Papier direkt im Hochvakuum mit Metall bedampft, nach dem zweiten Verfahren wird ein Fremdsubstrat mit einer Metallschicht bedampft, und diese wird dann auf das Papier übertragen. Das zweite Verfahren wird auch als Transfermetallisierung bezeichnet.

Für die direkte Bedampfung von Papier ist die Auswahl einer geeigneten Papierqualität ein entscheidender Faktor, ferner ist eine kostenaufwendige Vorbereitung des Papiers erforderlich. Diese Vorbereitung besteht entweder aus einer Versiegelung des Papiers mit einer Lackschicht oder aus einem Trocknungsschritt, bei dem der normale Wassergehalt des Papiers von 6 bis 7 % auf ca. 3 % reduziert wird. Nach der Metallbedampfung muß das Papier dann wieder auf den normalen Wassergehalt gebracht werden. Diese Schritte sind kosten- und zeitaufwendig.

Bei der Transfermetallisierung wird eine Kunststoffolie, meist auf Basis von Polyolefin oder Polyester, mit einem metallenen Überzug versehen. Die metallisierte Folie wird mit einem Haftkleber beschichtet und mit dem zu metallisierenden Papier, das in diesem Fall je nach Erfordernis der Endanwendung beliebig ausgewählt werden kann, zusammengebracht. Nach der Aushärtung des Haftklebers wird die Kunststoffolie von dem Verbund abgezogen, die Metallschicht verbleibt dabei auf dem Papier. Der Prozeß der Transfermetallisierung läßt sich nur dann wirtschaftlich durchführen, wenn die Kunststoffolie mehrfach zu verwenden ist. Herkömmliche Folien lassen sich normalerweise bis zu sechsmal wiederverwenden.

Ziel der vorliegenden Erfindung war es, eine Folie aus thermoplastischem Polymerem bereitzustellen, die bei dem Prozeß der Transfermetallisierung von Papier unter wirtschaftlichen Gesichtspunkten möglichst oft wiederverwendbar ist.

Erreicht wird dieses Ziel durch eine Transfermetallisierungsfolie der eingangs genannten Gattung, deren kennzeichnende Merkmale darin zu sehen sind, daß die Folie eine durch Koextrusion hergestellte Dreischichtfolie ist umfassend eine Basisschicht aus Propylen-Homopolymerem und beidseitig darauf aufgebrachten Deckschichten, daß die Basisschicht ein Additivdepot von migrierenden Monomeren enthält in einer Menge von 0,01 bis 2,0 Gew.-%, bezogen auf das Gewicht des die Basisschicht bildenden Polymeren, und daß die Deckschichten aus Polypropylen bestehen, das eine niedrigere Viskosität aufweist als das Polypropylen der Basisschicht.

Unter einem Additivdepot von migrierenden Monomeren ist ein Additivzusatz zu der Basisschicht von solchen Verbindungen zu verstehen, die in der Lage sind, aufgrund von Diffusionskräften nach und nach aus der Basisschicht in die Deckschichten überzutreten und dort ihre Wirkungen zu entfalten. Die in der Basisschicht enthaltenen Additive sind dabei insbesondere eine Kombination von Stearinsäureamid und von einem Hydroxyethylalkylamin mit Alkylketten im Bereich von 14 bis 20 C-Atomen.

Die Menge der Additive in der Basisschicht liegt bevorzugt im Bereich zwischen 0,01 und 1,0, besonders bevorzugt zwischen 0,1 und 0,5 Gew.-%, bezogen jeweils auf das die Basisschicht bildende Polypropylen.

Die Dicke der erfindungsgemäßen Folie liegt im Bereich zwischen 15 und 30 µm, bevorzugt zwischen 20 und 25 µm. Dabei weisen die Deckschichten Dicken zwischen 0,3 und 5 µm auf, bevorzugt zwischen 0,5 und 1,5 µm.

Die Deckschichten können bevorzugt zusätzlich noch die Gleitfähigkeit der Folie bzw. die Antiblockeigenschaften der Folie verbessernde inerte Zusatzmittel enthalten. Derartige Mittel sind z. B. anorganische Zusatzstoffe wie Calciumcarbonat, Bariumsulfat, Siliziumdioxid, Aluminiumsilikat und ähnliche. Die Mittel können in den Deckschichten in Mengen zwischen 0,1 und 1,0 Gew.-% enthalten sein, bezogen auf das Gewicht der Deckschichten. Bevorzugt wird Aluminiumsilikat in einer Menge von 0,2 bis 0,6 Gew.-%, bezogen auf das Gewicht der Deckschichten, eingesetzt.

Die Viskosität der die Basisschicht bzw. die Deckschichten bildenden Polymeren werden als Melt-Flow-Indices (MFI) angegeben. Das Polymere der Basisschicht weist dabei bevorzugt einen MFI 230/5 im Bereich von 5 bis 20 g/10 min auf, das Polymere der Deckschichten einen MFI 230/5 im Bereich von 15 bis 30 g/10 min, wobei jeweils die Viskosität des Polymeren der Basisschicht höher sein soll als die des Polymeren der Deckschichten.

Der besondere Vorteil der erfindungsgemäßen Folie ist darin zu sehen, daß die Folie beidseitig verwendbar ist. Wenn die Folie von einer Seite bedampft worden ist und ihre Metallschicht auf das Papier übertragen hat, kann sie im nächsten Verfahrensschritt auf der anderen Seite metallisiert werden usw. Die Folie wird auf diese Weise gleichmäßig von beiden Seiten abgenutzt. Hierdurch wird vermieden, daß es bei einseitiger Abnutzung innerhalb der Folie zur Ausbildung von Scherkräften kommt, woraus eine Rollneigung der Folie resultiert. Durch diese Rollneigung kommt es oft bei dem wiederholten Einsatz der Folie zu unerwünschten Problemen beim Aufwickeln der Folie, die schließlich durch die Bildung von Falten beim Aufwickeln dazu führen, daß die Folie unbrauchbar wird.

Als Metalle für welche die im vorstehenden beschriebene Folie geeignet ist, kommen insbesondere Metalle wie Gold, Silber, Kupfer, Nickel, Zinn oder Aluminium in Frage, gegebenenfalls auch Gemische oder Legierungen von wenigstens zweien dieser genannten Metalle, bevorzugt geeignet ist Aluminium. Die Metalle werden üblicherweise mit einer Schichtdicke von 5 bis 500 nm aufgebracht, je nachdem auf welche Art von Substrat die Metallschicht übertragen werden soll. Üblicherweise liegt die Dicke der Metallschicht iim Bereich von 10 bis 60 nm.

Verfahren zum Aufbringen der beschriebenen Metallschicht sind bekannt, diese kann beispielsweise durch Vakuumabscheidung, Kathodenaufsprühung, Plasmaaufsprühung, Dampfphasenplattierung, stromfreie Plattierung, Elektroplattierung und Aufziehen entweder allein oder in Kombination ausgebildet werden. Das Vakuumabscheidungsverfahren wird besonders für technische Arbeitsgänge bevorzugt.

## Beispiel

Eine Dreischichtfolie aus einer Basisschicht und zwei Deckschichten wurde durch Koextrusion hergestellt und anschließend biaxial streckorientiert. Die Folie hatte eine Gesamtdicke von 25 μm, die Basisschicht hatte eine Dicke von 23 μm, und die Schichtdicke beider Deckschichten betrug jeweils 1,0 μm. Die Basisschicht bestand aus einem Propylen-Homopolymer mit einem MFI 230/5 von 12 g/10 min und enthielt als Zusatz:

0,22 Gew.-% Hydroxyethylalkylamin, wobei die Alkylgruppe 18 C-Atome hatte;

0,25 Gew.-% Stearinsäureamid.

Die Deckschichten bestanden jeweils aus Polypropylen mit einem MFI 230/5 von 18 g/10 min und enthielten zusätzlich 0,4 Gew.-% Aluminiumsilikat.

Die Folie ließ sich zwanzigmal nacheinander ohne irgendwelche Schwierigkeiten für die Transfermetallisierung von Papier einsetzen, welches jeweils mit gleichbleibender Qualität erhalten wurde. Die Folie wurde jeweils im Hochvakuum mit einer Aluminiumschicht einer Dicke von 40 nm bedampft.

Erst dann zeigten sich durch den Verbrauch des Additivdepots in der Basisschicht geringfügige Fehlstellen bei der Übertragung der Metallschicht auf das Papier.

## Patentansprüche

1. Biaxial streckorientierte Transfermetallisierungsfolie auf Basis von Polypropylen, dadurch gekennzeichnet, daß die Folie eine durch Koextrusion hergestellte Dreischichtfolie ist umfassend eine Basisschicht aus Propylen-Homopolymerem und beidseitig darauf aufgebrachten Deckschichten, daß die Basisschicht ein Additivdepot von migrierenden Monomeren enthält in einer Menge von 0,01 bis 2,0 Gew.-%, bezogen auf das Gewicht des die Basisschicht bildenden Polymeren, und daß die Deckschichten aus Polypropylen bestehen, das eine niedrigere Viskosität aufweist als das Polypropylen der Basisschicht.

2. Folie nach Anspruch 1, dadurch gekennzeichnet, daß die Additive bevorzugt eine Kombination von Stearinsäureamid mit einem Hydroxyethylalkylamin sind, wobei die Alkylgruppen Kohlenwasserstoffreste mit einer Anzahl von C-Atomen im Bereich von 14 bis 30 darstellen.

3. Folie nach Anspruch 1 oder 2, dadurch gekennzeichnet, daß die Menge der Additive in der Basisschicht im Bereich von 0,01 bis 1,0 Gew.-%, bevorzugt im Bereich von 0,1 bis 0,5 Gew.-%, bezogen jeweils auf das Gewicht des die Basisschicht bildenden Polymeren, liegt.

4. Folie nach einem der Ansprüche 1 bis 3, dadurch gekennzeichnet, daß die Dicke der Gesamtfolie im Bereich zwischen 15 und 30 μm liegt, bevorzugt zwischen 20 und 25 μm.

5. Folie nach einem der Ansprüche 1 bis 4, dadurch gekennzeichnet, daß die Dicken der Deckschichten im Bereich zwischen 0,3 und 5 μm liegen, bevorzugt zwischen 0,5 und 1,5 μm.

6. Folie nach einem der Ansprüche 1 bis 5, dadurch gekennzeichnet, daß das Polypropylen der Basisschicht einen MFI 230/5 im Bereich von 5 bis 20 g/10 min aufweist und daß das Propylen der Deckschichten einen MFI 230/5 im Bereich von 15 bis 30 g/10 min aufweist.

7. Folie nach einem der Ansprüche 1 bis 6, dadurch gekennzeichnet, daß die Deckschichten die Gleitfähigkeit bzw. die Antiblockeigenschaften der Folie verbessernde inerte Zusatzmittel enthalten wie Calziumcarbonat, Bariumsulfat, Siliziumdioxid, Aluminiumsilikat in einer Menge von 0,1 bis 1,0 Gew.-%, bezogen auf das Gewicht des die Deckschichten bildenden Polymeren.

8. Folie nach einem der Ansprüche 1 bis 7, dadurch gekennzeichnet, daß die Deckschichten Aluminiumsilikat in einer Menge von 0,2 bis 0,6 Gew.-%, bezogen auf das Gewicht des die Deckschichten bildenden Polymeren, enthält.

## Claims

1. Biaxially draw-oriented transfer metallizing film based on polypropylene, wherein the film is a three-layer film produced by coextrusion, comprising a propylene homopolymer base layer and top layers applied on each side of the base layer, the base layer contains an additive depot of migrating monomers in an amount from 0.01 to 2.0 percent by weight, relative to the weight of the polymer forming the base layer and the top layers consist of polypropylene having a lower viscosity than the polypropylene of the base layer.

2. A film as claimed in claim 1, wherein the additives preferably comprise a combination or stearic acid amide with a hydroxyethylalkylamine, the alkyl groups being hydrocarbon radicals having from 14 to 30 carbon atoms.

3. A film as claimed in claim 1 or claim 2, wherein the amount of additives contained in the base layer is in the range from 0.01 to 1.0 percent by weight, preferably from 0.1-to 0.5 percent by weight, in each case relative to the weight of the polymer forming the base layer.

4. A film as claimed in any of claims 1 to 3, wherein the thickness of the total film is in the range between 15 and 30 μm, preferably between 20 and 25 μm.

5. A film as claimed in any of claims 1 to 4, wherein the thicknesses of the top layers are in the range between 0.3 and 5 μm, preferably between 0.5 and 1.5 μm.

6. A film as claimed in any of claims 1 to 5, wherein the polypropylene of the base layer has an MFI 230/5 in the range from 5 to 20 g/10 min and the polypropylene of the top layers has an MFI 230/5 in the range from 15 to 30 g/10 min.

7. A film as claimed in any of claims 1 to 6, wherein the top layers contain inert additives which improve the slip properties or blocking resistance of the film, such as, for example, calcium carbonate, barium sulfate, silicon dioxide, aluminium silicate, in an amount from 0.1 to 1.0 percent by weight, relative to the weight of the polymer forming the top layers.

8. A film as claimed in any of claims 1 to 7, wherein the top layers contain aluminium silicate in an amount from 0.2 to 0.6 percent by weight, relative to the weight of the polymer forming the top layers.

## Revendications

1. Feuille pour métallisation par transfert orientée par étirement suivant ses deux axes à base de polypropylène, caractérisée en ce que la feuille est une feuille à trois couches fabriquée par co-extrusion comprenant une couche de base d'homopolymère de propylène et des couches de recouvrement appliquées dessus des deux côtés, en ce que la couche de base contient un réservoir d'additifs de monomères migrants en quantité de 0,01 à 2,0 % en poids par rapport au poids du polymère formant la couche de base, et en ce que les couches de recouvrement sont constituées de polypropylène qui présente une viscosité plus faible que le polypropylène de la couche de base.

2. Feuille selon la revendication 1, caractérisée en ce que les additifs se composent de préférence d'une combinaison d'amide de l'acide stéarique avec une hydroxyéthylalkylamine, les groupes alkyle représentant des radicaux hydrocarbonés ayant un nombre d'atomes de C compris entre. 14 à 30.

3. Feuille selon la revendication 1 ou 2, caractérisée en ce que la quantité d'additifs dans la couche de base est comprise entre 0,01 et 1,0 % en poids, de préférence entre 0,1 et 0,5 % en poids par rapport au poids du polymère formant la couche de base.

4. Feuille selon l'une quelconque des revendications 1 à 3, caractérisée en ce que l'épaisseur de la feuille totale est comprise entre 15 et 30 micromètres, de préférence entre 20 et 25 micromètres.

5. Feuille selon l'une quelconque des revendications 1 à 4, caractérisée en ce que l'épaisseur des couches de recouvrement est comprise entre 0,3 et 5 micromètres, de préférence entre 0,5 et 1,5 micromètre.

6. Feuille selon l'une quelconque des revendications 1 à 5, caractérisée en ce que le polypropylène de la couche de base présente un MFI 230/5 compris entre 5 et 20 g/10 min et en ce que le polypropylène des couches de recouvrement présente un MFI 230/5 compris entre 15 et 30 g/10 min.

7. Feuille selon l'une quelconque des revendications 1 à 6, caractérisée en ce que les couches de recouvrement contiennent des additifs inertes qui améliorent l'aptitude au glissement ou les propriétés antibloquantes de la feuille, comme le carbonate de calcium, le sulfate de baryum, le dioxyde de silicium, le silicate d'aluminium en quantité de 0,1 à 1,0 % en poids par rapport au poids du polymère formant les couches de recouvrement.

8. Feuille selon l'une quelconque des revendications 1 à 7, caractérisée en ce que les couches de recouvrement contiennent du silicate d'aluminium en quantité de 0,2 à 0,6 % en poids par rapport au poids du polymère formant les couches de recouvrement.